# FASCICULE DE BREVET EUROPEEN

(11) **EP 3 097 428 B1**
(45) Date de publication et mention de la délivrance du brevet: **18.12.2019**
(21) Numéro de dépôt: 15705774.6
(22) Date de dépôt: 12.01.2015
(51) Int. Cl.: G01R 31/392, G01R 31/389, G01R 31/28

(54) **PROCEDE ET DISPOSITIF DE DETERMINATION DE L'IMPEDANCE D'UN ELEMENT DE STOCKAGE D'ENERGIE D'UNE BATTERIE**
VERFAHREN UND VORRICHTUNG ZUR BESTIMMUNG DER IMPEDANZ EINES ENERGIESPEICHERELEMENTS EINER BATTERIE
METHOD AND DEVICE FOR DETERMINING THE IMPEDANCE OF AN ENERGY STORAGE ELEMENT OF A BATTERY

(30) Priorité: 22.01.2014 FR 1450508
(43) Date de publication de la demande: 30.11.2016
(73) Titulaire: Commissariat à l'Energie Atomique et aux Energies Alternatives, 75015 Paris (FR)
(72) Inventeur: RANIERI, Marco, F-38610 Gieres (FR); HEIRIES, Vincent, F-38430 Saint Jean De Moirans (FR)
(74) Mandataire: Cabinet Beaumont
(86) Numéro de dépôt international: PCT/EP2015/050436
(87) Numéro de publication internationale: WO 2015/110307

(56) Documents cités:
- EP-A2- 2 520 944
- EP-A2- 2 530 480
- AL NAZER R ET AL: "Broadband Identification of Battery Electrical Impedance for HEVs", IEEE TRANSACTIONS ON VEHICULAR TECHNOLOGY, IEEE SERVICE CENTER, PISCATAWAY, NJ, US, vol. 62, no. 7, 1 septembre 2013 (2013-09-01), pages 2896-2905, XP011526702, ISSN: 0018-9545, DOI: 10.1109/TVT.2013.2254140 [extrait le 2013-09-11]
- FAIRWEATHER A J ET AL: "Battery parameter identification with Pseudo Random Binary Sequence excitation (PRBS)", JOURNAL OF POWER SOURCES, ELSEVIER SA, CH, vol. 196, no. 22, 22 juin 2011 (2011-06-22), pages 9398-9406, XP028283666, ISSN: 0378-7753, DOI: 10.1016/J.JPOWSOUR.2011.06.072 [extrait le 2011-07-08]

## Description

La présente demande de brevet revendique la priorité de la demande de brevet français FR14/50508 qui sera considérée comme faisant partie intégrante de la présente description.

### Domaine

La présente demande concerne le domaine des batteries électriques et vise plus particulièrement un procédé et un dispositif de détermination de l'impédance d'un élément de stockage d'énergie d'une batterie.

### Exposé de l'art antérieur

Une batterie électrique est un groupement de plusieurs cellules élémentaires rechargeables (piles, accumulateurs, etc.) reliées en série et/ou en parallèle entre deux noeuds ou bornes de fourniture de tension.

Dans certaines applications, on souhaite connaitre l'impédance d'un élément de stockage d'énergie de la batterie tel qu'une cellule élémentaire de la batterie, un module de plusieurs cellules élémentaires reliées en série et/ou en parallèle entre deux noeuds de la batterie, ou la batterie elle-même. La connaissance de l'impédance de l'élément à certaines fréquences peut notamment permettre de déterminer des informations relatives à l'état de l'élément telles que son état de charge, aussi appelé SOC (de l'anglais "State of Charge"), son état de santé, aussi appelé SOH (de l'anglais "State of Health"), son état d'énergie, aussi appelé SOE (de l'anglais "State of Energy"), une dégradation (augmentation) de sa résistance interne, une dégradation (diminution) de sa capacité, etc. A titre d'exemple, la connaissance de l'impédance d'un élément de stockage d'énergie d'une batterie en technologie lithium-ion dans une bande de fréquence basse, typiquement inférieure à 5 Hz, peut permettre de déterminer le SOC de l'élément, et la connaissance de l'impédance de l'élément dans une bande de fréquence plus élevée, typiquement entre 10 et 100 Hz, peut permettre de déterminer le SOH de l'élément.

Les procédés et dispositifs existants de mesure de l'impédance d'un élément de stockage d'énergie d'une batterie présentent divers inconvénients qu'il serait souhaitable de pallier au moins en partie.

L'article intitulé "Broadband Identification of Battery Electrical Impedance for HEVs" de Al Nazer et al. (IEEE Transactions on Vehicular Technology), décrit un exemple d'un procédé de détermination de l'impédance d'une batterie.

### Résumé

Ainsi, un mode de réalisation prévoit un procédé de détermination de l'impédance d'un élément de stockage d'énergie d'une batterie électrique, comprenant les étapes suivantes : appliquer à l'élément une séquence prédéterminée de variations de courant ; mesurer les variations de tension aux bornes de l'élément en réponse à l'application de la séquence ; et déterminer l'impédance de l'élément à partir des variations de tension mesurées, dans lequel la séquence est une séquence non binaire obtenue par convolution d'une séquence binaire pseudo-aléatoire avec des coefficients d'un filtre à réponse impulsionnelle finie.

Selon un mode de réalisation de la présente invention, le filtre est choisi de façon que le spectre en fréquence de la séquence présente une bande passante de largeur comprise entre 1 Hz et 50 kHz présentant un niveau approximativement constant, c'est-à-dire variant de moins de 10 dB, et présente une atténuation inférieure à -30 dB en dehors de cette bande passante.

Selon un mode de réalisation de la présente invention, le filtre est un filtre en racine de cosinus surélevé.

Selon un mode de réalisation de la présente invention, le filtre est un filtre en cosinus surélevé.

Selon un mode de réalisation de la présente invention, la séquence non binaire est modulée sur un signal porteur périodique avant d'être appliquée à l'élément.

Selon un mode de réalisation de la présente invention, le signal périodique est sinusoïdal.

Un autre mode de réalisation prévoit un dispositif de détermination de l'impédance d'un élément de stockage d'énergie d'une batterie électrique, comprenant un circuit adapté à : appliquer à l'élément une séquence prédéterminée de variations de courant ; mesurer les variations de tension aux bornes de l'élément en réponse à l'application de la séquence ; et déterminer l'impédance de l'élément à partir des variations de tension mesurées, dans lequel la séquence est une séquence non binaire obtenue par convolution d'une séquence binaire pseudo-aléatoire avec des coefficients d'un filtre à réponse impulsionnelle finie.

Selon un mode de réalisation de la présente invention, le circuit comprend une branche de décharge destinée à être connectée en parallèle de l'élément, cette branche comportant un transistor adapté à être commandé dans une zone de fonctionnement linéaire pour appliquer à l'élément des variations de courant non binaires.

Selon un mode de réalisation de la présente invention, le transistor est commandé par l'intermédiaire d'un amplificateur opérationnel, et une boucle de contre-réaction relie la branche à une borne d'entrée de l'amplificateur.

Selon un mode de réalisation de la présente invention, le circuit comprend un circuit d'alimentation adapté à emmagasiner de l'énergie électrique dans un condensateur avant une phase de mesure d'impédance, en vue d'alimenter le dispositif pendant la phase de mesure.

Un autre mode de réalisation prévoit un assemblage comportant : une batterie électrique comportant au moins un élément de stockage d'énergie ; et un dispositif de gestion de la batterie couplé à la batterie, le dispositif de gestion comportant au moins un dispositif du type susmentionné, adapté à mesurer l'impédance de l'élément de stockage.

Selon un mode de réalisation de la présente invention, la batterie comporte plusieurs éléments de stockage, et le dispositif de gestion comporte plusieurs dispositifs de mesure d'impédance affectés respectivement aux différents éléments de stockage, les différents dispositifs de mesure d'impédance étant adaptés à appliquer des séquences de variations de courant différentes aux différents éléments de stockage.

Selon un mode de réalisation de la présente invention, le dispositif de gestion est adapté à identifier les différents éléments par la séquence de variations de courant qui leur est appliquée lors d'une mesure d'impédance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre de façon schématique et partielle un exemple d'un dispositif de mesure d'impédance d'un élément de stockage d'énergie d'une batterie ;
la figure 2 est un diagramme représentant un exemple d'une séquence de commande en variation de courant qui peut être appliquée à un élément de stockage d'énergie d'une batterie pour mesurer son impédance ;
la figure 3 est un diagramme représentant le spectre en fréquence d'une séquence de variations de courant du type représenté en figure 2 ;
la figure 4 est un diagramme représentant des coefficients d'un exemple d'un filtre à réponse impulsionnelle finie ;
la figure 5 est un diagramme représentant un exemple d'une séquence de commande en variation de courant qui peut être appliquée à un élément de stockage d'énergie pour mesurer son impédance selon un mode de réalisation ;
la figure 6 est un diagramme représentant le spectre en fréquence d'une séquence de variations de courant du type représenté en figure 5 ;
la figure 7 est un diagramme représentant le spectre en fréquence d'une séquence de variations de courant qui peut être appliquée à un élément de stockage d'énergie pour mesurer son impédance selon une variante de réalisation ;
la figure 8 est un schéma électrique illustrant un exemple d'un mode de réalisation d'un dispositif de mesure d'impédance d'un élément de stockage d'énergie d'une batterie ;
la figure 9 est un schéma électrique illustrant une première variante de réalisation du dispositif de mesure d'impédance de la figure 8 ;
la figure 10 est un schéma électrique illustrant une deuxième variante de réalisation du dispositif de mesure d'impédance de la figure 8 ; et
la figure 11 est un schéma électrique illustrant une troisième variante de réalisation du dispositif de mesure d'impédance de la figure 8.

### Description détaillée

Par souci de clarté, de mêmes éléments ont été désignés par de mêmes références aux différentes figures et, de plus, les diverses figures ne sont pas tracées à l'échelle. En outre, seuls les éléments utiles à la compréhension des modes de réalisation décrits ont été détaillés. En particulier, les utilisations qui peuvent être faites des mesures d'impédance réalisées à l'aide des procédés et dispositifs proposés n'ont pas été détaillées, les modes de réalisation décrits étant compatibles avec toutes les utilisations connues de mesures d'impédance d'éléments de stockage d'énergie de batterie.

On s'intéresse ici plus particulièrement à des procédés et dispositifs de mesure d'impédance pouvant être mis en oeuvre par ou intégrés dans un système de gestion de batterie embarqué, aussi appelé BMS, de l'anglais "Battery Management System", c'est-à-dire un système électronique couplé de façon permanente à la batterie, adapté à mettre en oeuvre diverses fonctions pendant le fonctionnement normal de la batterie telles que des fonctions de protection de la batterie pendant des phases de charge ou de décharge, des fonctions d'équilibrage des cellules de la batterie, des fonctions de surveillance de l'état de charge et/ou de l'état de vieillissement de la batterie, etc. Les modes de réalisation décrits ne se limitent toutefois pas à ce cas particulier. A titre de variante, les procédés et dispositifs de mesure d'impédance décrits dans la présente demande peuvent être mis en oeuvre par ou intégrés dans des outils de diagnostic légers non embarqués, destinés à être connectés à la batterie uniquement pendant des phases de maintenance de la batterie, par exemple des outils destinés à des garagistes dans le cas de batteries pour véhicules électriques.

Pour mesurer l'impédance d'un élément de stockage d'énergie d'une batterie à une fréquence f, on peut prévoir de soumettre l'élément à une variation de courant sinusoïdale de fréquence f. La variation de tension aux bornes de l'élément en réponse à la variation de courant est alors mesurée, et l'impédance de l'élément à la fréquence f est déterminée à partir de la variation de tension mesurée. Pour mesurer l'impédance de l'élément à plusieurs fréquences, l'opération peut être répétée aux diverses fréquences d'intérêt. Des mesures d'impédance de ce type, dites à balayage de spectre, peuvent par exemple être réalisées en laboratoire lorsque la batterie est à l'arrêt et éventuellement démontée. Un inconvénient des mesures à balayage de spectre est qu'elles sont relativement longues ce qui peut poser problème pour une mise en oeuvre dans un système de gestion embarqué de type BMS, ou dans un outil de diagnostic léger devant fournir une mesure d'impédance rapide sur une gamme de fréquence relativement large. On notera en outre que les BMS existants ne sont pas adaptés à appliquer une variation de courant sinusoïdale à un élément de stockage d'énergie d'une batterie, mais peuvent uniquement appliquer des séquences binaires de variations de courant commutant de façon relativement abrupte entre deux états.

Alternativement, pour mesurer l'impédance d'un élément de stockage d'énergie d'une batterie simultanément à plusieurs fréquences, une autre solution est de soumettre l'élément à une variation de courant large bande, c'est-à-dire une variation dont le spectre en fréquence contient une pluralité de fréquences d'intérêt. La variation de tension aux bornes de l'élément en réponse à la variation de courant large bande est alors mesurée et analysée pour déterminer l'impédance de l'élément aux diverses fréquences du signal d'excitation en courant. Ceci permet une mesure plus rapide que par une méthode à balayage de spectre du type susmentionné. Toutefois, pour mettre en oeuvre une mesure d'impédance large bande dans un BMS ou dans un outil de diagnostic léger, une difficulté réside dans la génération d'un signal d'excitation présentant un spectre en fréquence bien adapté à la mesure que l'on souhaite effectuer.

Un exemple d'un système de gestion de batterie embarqué de type BMS, incluant un dispositif de mesure d'impédance de cellules de la batterie, a été décrit dans la demande de brevet français N°FR1353656 déposée par la demanderesse le 24 avril 2013, dont le contenu est considéré comme faisant partie intégrante de la présente description.

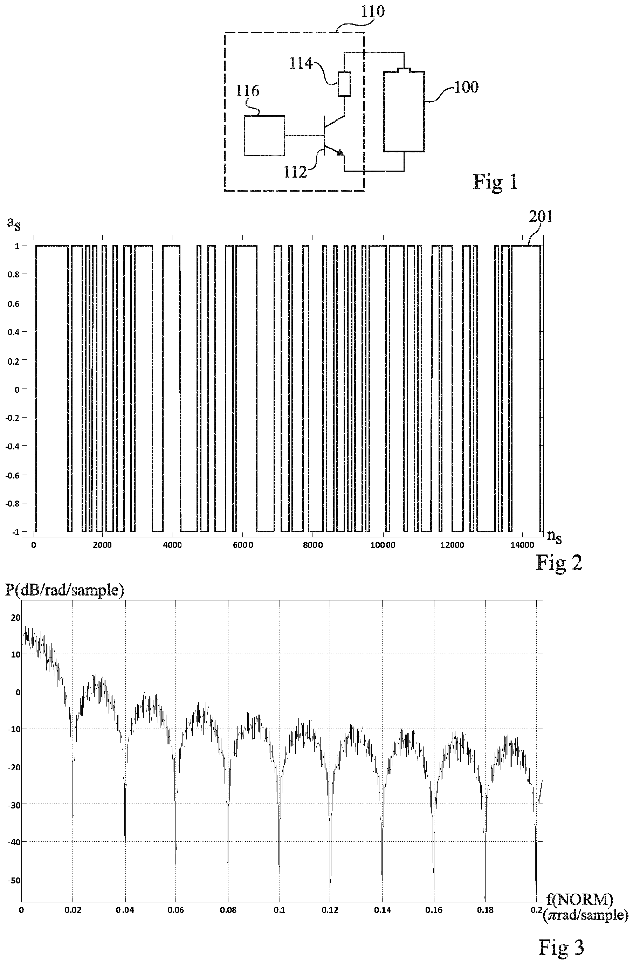

La figure 1 illustre de façon schématique et partielle un exemple d'un dispositif de mesure d'impédance du type décrit dans la demande FR1353656 susmentionnée. Plus particulièrement, la figure 1 est un schéma électrique représentant un élément 100 de stockage d'énergie électrique d'une batterie, et un circuit 110 connecté aux bornes de l'élément de stockage, le circuit 110 étant adapté à appliquer à l'élément 100 une séquence binaire de variations de courant en vue de mesurer son impédance. Dans cet exemple, le circuit 110 comprend une branche comportant en série un transistor de puissance 112 et une résistance de décharge 114, cette branche étant connectée en parallèle aux bornes de l'élément 100. Le circuit 110 comprend en outre un circuit de contrôle 116, par exemple un microcontrôleur, relié à un noeud de commande du transistor 112 et adapté à fermer ou ouvrir le transistor 112 (pour dériver ou non un courant de l'élément 110) selon une séquence de commande binaire prédéfinie. A titre d'exemple, le circuit de contrôle 116 peut être alimenté par l'élément 100 lui-même, ou par une source d'énergie annexe.

Pour mesurer l'impédance de l'élément 100, le circuit de contrôle 116 applique au transistor 112 la séquence de commande binaire prédéfinie à un rythme ou taux (nombre d'échantillons par secondes) f_{S} choisi en fonction de la fréquence pour laquelle on souhaite mesurer l'impédance. Dans la suite de la description, le taux d'application d'une séquence numérique de commande (binaire ou non) pourra aussi être désigné par l'expression "fréquence de la séquence". L'élément 100 subi ainsi une séquence binaire correspondante de variations de courant. La variation de tension aux bornes de l'élément 100 en réponse à cette variation de courant est mesurée, et une valeur d'impédance de l'élément 100 est déterminée à partir de la variation de tension mesurée. Pour mesurer l'impédance de l'élément 110 à plusieurs fréquences d'intérêt distinctes, l'opération peut être répétée en modifiant le taux f_{S} d'application de la séquence de commande binaire. On notera que la mesure de la variation de tension aux bornes de l'élément 100 en réponse à l'excitation en courant appliquée via le transistor 112, peut être effectuée "localement", c'est-à-dire directement aux bornes de l'élément 100, ou "à distance" depuis les bornes principales de la batterie. La mesure d'impédance peut être effectuée pendant le fonctionnement normal de la batterie, sans qu'il ne soit nécessaire d'arrêter ou de démonter la batterie. Dans la demande FR1353656 susmentionnée, il est proposé d'utiliser une séquence binaire pseudo-aléatoire pour exciter l'élément 100 en courant lors d'une mesure d'impédance. Plus particulièrement, il est proposé d'affecter à chaque élément de stockage d'énergie de la batterie une séquence binaire pseudo-aléatoire spécifique, et lorsqu'une mesure d'impédance d'un élément doit être effectuée, d'exciter l'élément en courant selon la séquence binaire pseudo-aléatoire spécifique de cet élément. Un avantage est que ceci permet, lorsque la variation de tension de l'élément est mesurée "à distance" depuis les bornes principales de la batterie, d'identifier l'élément excité à partir de la séquence de variations de tension mesurée.

Lorsqu'une séquence binaire de variations de courant est appliquée à l'élément dont on souhaite mesurer l'impédance, comme c'est le cas dans la demande FR1353656 susmentionnée, le spectre en fréquence de la variation de courant contient un grand nombre de fréquences, ce qui pourrait laisser penser qu'une mesure d'impédance large bande peut être réalisée.

En pratique, les inventeurs ont toutefois déterminé que pour réaliser une mesure d'impédance large bande précise, il convient que le spectre en fréquence du signal d'excitation soit le plus plat possible dans la bande d'intérêt. Ceci permet que le signal d'excitation sollicite l'élément avec sensiblement la même puissance à chaque fréquence de la bande d'intérêt, et par conséquent que le rapport signal sur bruit de la mesure d'impédance soit sensiblement le même à toutes les fréquences de la bande d'intérêt. De plus, pour minimiser la consommation d'énergie liée à la mesure d'impédance, il convient que le spectre en fréquence du signal d'excitation soit proche de zéro en dehors de la bande d'intérêt, afin de ne pas solliciter inutilement des fréquences non désirées.

Comme cela est illustré par les figures 2 et 3 détaillées ci-après, lorsqu'une séquence binaire (ON/OFF) de variations de courant est appliquée, le spectre de ce signal d'excitation est un spectre à support fréquentiel infini présentant un lobe principal et, de part et d'autre de ce lobe, des lobes d'amplitude décroissante. Ce type de spectre n'est pas adapté à la réalisation d'une mesure d'impédance large bande précise et à faible consommation énergétique.

La figure 2 est un diagramme représentant un exemple d'une séquence de commande binaire pseudo-aléatoire 201 susceptible d'être appliquée sur le noeud de commande du transistor 112 de la figure 1, afin de soumettre l'élément 100 à une séquence de variations de courant de même forme en vue de mesurer son impédance. Sur la figure 2, l'axe des abscisses représente le numéro n_{S} des échantillons de la séquence, et l'axe des ordonnées représente la valeur a_{S} des échantillons. Sur la figure 2, on a affecté une amplitude a_{S} égale à 1 à l'état haut de la séquence binaire, correspondant à un état passant du transistor 112, et une amplitude a_{S} égale à -1 à l'état bas de la séquence binaire, correspondant à un état bloqué du transistor 112. Ces valeurs sont toutefois purement arbitraires et ne correspondent pas nécessairement à des valeurs réelles de signaux à appliquer sur la grille du transistor 112. De plus, sur la figure, un grand nombre d'échantillons a été représenté (environ 15000). En pratique, la séquence binaire pseudo-aléatoire appliquée pour effectuer une mesure d'impédance peut avoir un nombre d'échantillons différent. Par ailleurs, bien que cela n'apparaisse pas sur la figure 2, au sens de la présente demande, une séquence binaire pseudo-aléatoire comportant N échantillons (N étant un nombre entier supérieur à 1) peut soit réellement comprendre une suite pseudo-aléatoire de N échantillons de 1 bit, soit être obtenue par répétition (concaténation) d'un motif pseudo-aléatoire comportant un nombre d'échantillons de 1-bit inférieur à N, par exemple un motif pseudo-aléatoire comportant un nombre d'échantillons de 1 bit compris dans la plage allant de 32 à 256.

La figure 3 est un diagramme représentant le spectre en fréquence d'une séquence binaire pseudo-aléatoire de variations de courant du type représenté en figure 2. Sur la figure 3, l'axe des abscisses représente la fréquence f(NORM), normalisée par rapport à une fréquence d'échantillonnage fₑ du dispositif d'application de la séquence binaire, exprimée en π radians par échantillon (n rad/sample). Une valeur α quelconque en abscisse de la figure 3 correspond, en Hertz, à la valeur (α*fₑ)/2. L'axe des ordonnées représente le niveau de puissance, en décibel par radian par échantillon (dB/rad/sample), du signal d'excitation en courant, aux différentes fréquences du spectre.

Il ressort clairement de la figure 3 que le spectre d'une séquence binaire pseudo-aléatoire ne présente pas une forme adaptée à la réalisation d'une mesure d'impédance large bande précise et à faible consommation énergétique. On pourrait au mieux faire l'hypothèse que le spectre de la figure 3 est suffisamment plat pour effectuer une mesure d'impédance large bande dans la première moitié du premier lobe, c'est-à-dire entre les valeurs 0 et 0,01 en fréquence normalisée. Cette plage est toutefois trop restreinte pour obtenir en une seule mesure l'impédance de l'élément de stockage d'énergie à toutes les fréquences susceptibles de présenter un intérêt. Pour balayer toute la plage des fréquences d'intérêt, il convient donc de répéter la mesure un nombre de fois relativement important, en faisant varier la fréquence f_{S} de la séquence binaire. Le rendement énergétique de chaque mesure est en outre relativement faible puisqu'un grand nombre de fréquences non exploitées est excité à chaque application de la séquence binaire.

Selon un aspect, on prévoit ici d'effectuer une mesure d'impédance large bande en excitant l'élément de stockage d'énergie à l'aide d'une séquence prédéfinie de variations de courant, cette séquence étant non binaire - c'est-à-dire qu'elle présente un nombre de niveaux de variation supérieur à deux - et étant choisie de façon que son spectre en fréquence soit approximativement plat dans la bande de fréquence d'intérêt, et le plus faible possible en dehors de cette bande. A titre d'exemple non limitatif, la séquence de variations de courant est choisie de façon que son spectre en fréquence présente une bande passante approximativement plate de largeur comprise entre 1 Hz et 50 kHz, une ondulation en bande passante inférieure à 10 dB, une zone de transition entre la bande passante et une bande atténuée de largeur comprise entre 1 mHz et 1 kHz, et une atténuation en bande atténuée supérieure à 30 dB et de préférence comprise entre 50 et 80 dB.

Pour obtenir un spectre adapté à une mesure d'impédance large bande précise et à fort rendement énergétique, les inventeurs ont déterminé que la séquence de variations de courant à appliquer à l'élément de stockage d'énergie peut être obtenue par convolution d'une séquence binaire pseudo-aléatoire quelconque, par exemple du type décrit en relation avec la figure 2, avec les coefficients d'un filtre à réponse impulsionnelle finie. A titre d'exemple non limitatif, la séquence binaire pseudo-aléatoire peut être une séquence de Gold ou une séquence de Kasami. A titre d'exemple, le filtre peut être un filtre en racine de cosinus surélevé ou un filtre en cosinus surélevé. Les modes de réalisation décrits ne se limitent toutefois pas à ces exemples particuliers. Plus généralement, l'homme du métier saura déterminer d'autres types de filtres à réponse impulsionnelle finie adaptés à obtenir la forme de spectre recherchée, le filtre choisi étant de préférence un filtre à réponse impulsionnelle finie à phase linéaire. Afin de réduire la complexité du filtre, on choisira de préférence un filtre symétrique. On notera que si l'on souhaite analyser plusieurs bandes de fréquences d'intérêt distinctes, plusieurs filtres (et donc plusieurs jeux de coefficients) peuvent être prévus pour générer plusieurs séquences de commande à partir d'une même séquence binaire pseudo-aléatoire.

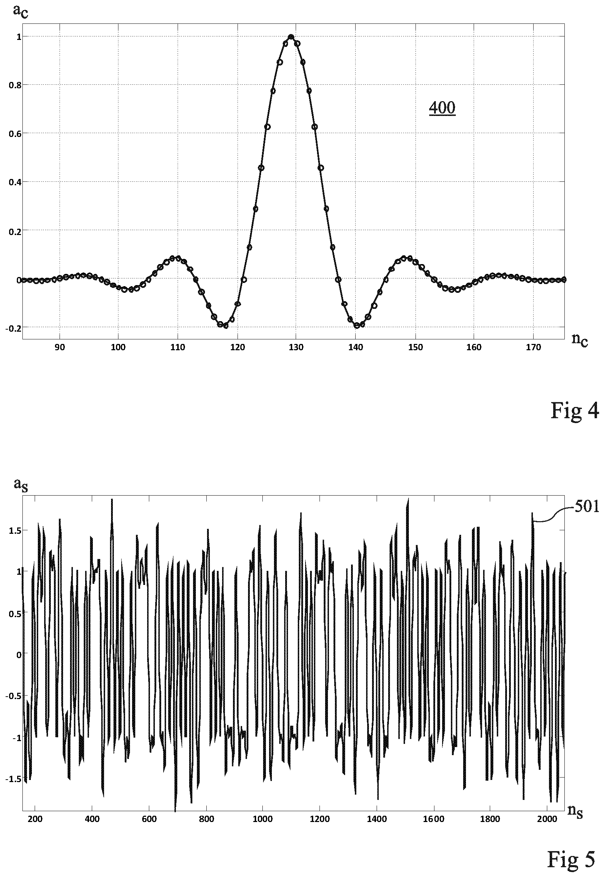

La figure 4 est un diagramme représentant des coefficients d'un exemple d'un filtre à réponse impulsionnelle finie 400 en racine de cosinus surélevé, pouvant être utilisé pour définir, à partir d'une séquence binaire pseudo-aléatoire, une séquence de variations de courant à appliquer à l'élément de stockage d'énergie en vue de mesurer son impédance. Sur la figure 4, l'axe des abscisses représente le numéro n_{C} des coefficients du filtre, et l'axe des ordonnées représente la valeur normalisée a_{C} des coefficients.

La figure 5 est un diagramme représentant un exemple d'une séquence de commande en variation de courant 501 adaptée à être appliquée à un élément de stockage d'énergie d'une batterie pour mesurer son impédance. Sur la figure 5, l'axe des abscisses représente le numéro n_{S} des échantillons de la séquence, et l'axe des ordonnées représente la valeur normalisée a_{S} des échantillons. Les échantillons de la séquence de la figure 5 peuvent être quantifiés sur un nombre de bits supérieur à 1, par exemple sur un nombre de bits compris dans la plage allant de 4 à 64 bits. La séquence de l'exemple de la figure 5 correspond à la convolution d'une séquence binaire pseudo-aléatoire du type décrit en relation avec la figure 2 avec les coefficients d'un filtre à réponse impulsionnelle finie du type représenté en figure 4. A titre d'exemple, la fréquence f_{S} de la séquence de commande de la figure 5 peut être choisie entre 1 Hz et 1 kHz.

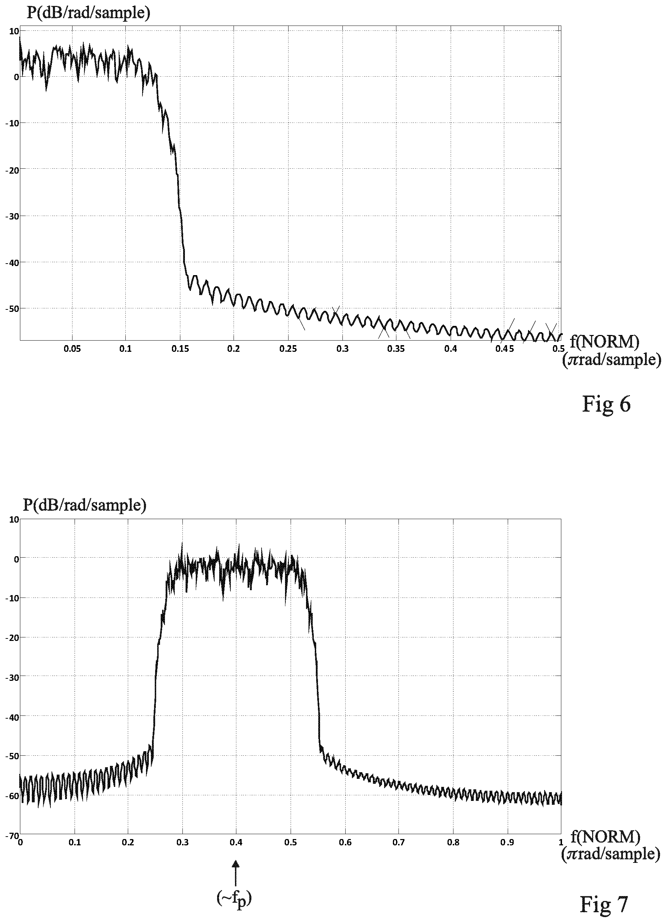

La figure 6 est un diagramme représentant le spectre en fréquence de la séquence de commande en variation de courant représentée en figure 5. Sur la figure 6, l'axe des abscisses représente la fréquence f(NORM), normalisée par rapport à une fréquence d'échantillonnage fₑ du dispositif d'application de la séquence binaire, et exprimée en π radians par échantillon (π rad/sample). Comme dans l'exemple de la figure 3, une valeur α quelconque en abscisse de la figure 6 correspond, en Hertz, à la valeur (α*fₑ)/2. L'axe des ordonnées représente le niveau de puissance, en décibel par radian par échantillon (dB/rad/sample), du signal d'excitation en courant, aux différentes fréquences du spectre.

Il apparaît clairement sur la figure 6 que le spectre de la séquence de commande en variations de courant de la figure 5 est bien adapté à une mesure d'impédance large bande précise et à fort rendement énergétique. En effet, le spectre de la figure 6 est approximativement plat dans la bande comprise entre 0 et 0,12 π radians par échantillon, soit entre 0 et 0,06*f_{S} en Hertz, et est fortement atténué (inférieur à -30 dB) en dehors de cette bande. A titre d'exemple non limitatif, si la fréquence d'échantillonnage f_{S} du système est de l'ordre de 16 kHz, une mesure d'impédance large bande peut être réalisée en une seule fois dans une bande de l'ordre de 0 à 1000 Hz. Pour ajuster la forme du spectre et notamment la largeur de sa bande passante, on peut par exemple adapter la forme du filtre à réponse impulsionnelle finie, par exemple en réglant un paramètre du filtre couramment désigné dans la technique par le terme facteur de roll-off.

Selon une variante de réalisation, la séquence non binaire de variations de courant appliquée à l'élément de stockage d'énergie peut être modulée sur une porteuse de fréquence fₚ, de façon à décaler en fréquence la bande utile du signal d'excitation et à la centrer sur la fréquence fₚ. Ceci permet d'effectuer une mesure d'impédance large bande à des fréquences plus élevées, par exemple de l'ordre de plusieurs dizaines de Hz à plusieurs dizaines de kHz (mais seulement dans une bande spécifique). Pour réaliser cette modulation, une séquence non binaire de commande en variation de courant du type décrit en relation avec la figure 5 - obtenue par convolution d'une séquence binaire pseudo-aléatoire avec un filtre à réponse impulsionnelle finie - peut par exemple être multipliée par un signal porteur de fréquence fₚ, par exemple le signal sin(2π*fₚ*t).

La figure 7 est un diagramme représentant, à titre d'exemple, le spectre en fréquence d'une séquence de commande en variation de courant correspondant à la séquence de la figure 5 modulée par une fréquence porteuse de fréquence fₚ = 0,2*f_{S} (soit 0,4 π radians par échantillon en fréquence normalisée). A titre d'exemple non limitatif, la fréquence d'échantillonnage f_{S} peut être de l'ordre de 10 kHz, et la fréquence fₚ de l'ordre de 2 kHz.

Comme cela apparaît sur la figure 7, le spectre de la séquence de variations de courant modulée à la fréquence fₚ est similaire à celui de la figure 6 mais centré sur la fréquence fₚ. Plus particulièrement, dans l'exemple de la figure 7, le spectre de la séquence de variations de courant est approximativement plat dans la bande comprise entre fₚ - 0,12 π radians par échantillon et fₚ + 0,12 π radians par échantillon, soit, en Hz, entre fₚ-0,06*f_{S} et fₚ+0,06*f_{S}.

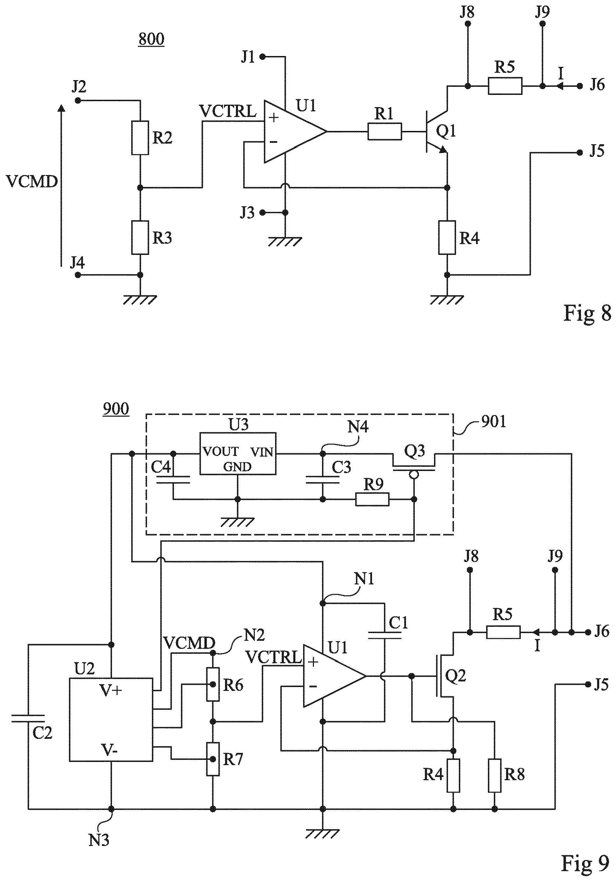

Pour pouvoir appliquer à un élément de stockage d'énergie une séquence de variations de courant non binaire, du type décrit en relation avec les figures 5 à 7, on prévoit un dispositif de mesure d'impédance comportant un circuit d'excitation en courant de l'élément à tester, ce circuit étant adapté à faire subir à l'élément des variations de courant dont l'amplitude peut prendre un nombre de niveaux supérieur à deux. Des exemples de réalisation de tels circuits seront décrits ci-après en relation avec les figures 8 et 9. Les modes de réalisation décrits ne se limitent toutefois pas à ces exemples particuliers. Plus généralement, tout circuit adapté à faire subir à l'élément de stockage une séquence non binaire de variations de courant peut être utilisé. A titre d'exemple, un tel circuit peut comprendre une branche de décharge connectée en parallèle aux bornes de l'élément dont on souhaite mesurer l'impédance, cette branche comportant au moins un transistor, par exemple un transistor MOS ou un transistor bipolaire, ce transistor étant commandé par un circuit de contrôle dans sa zone de fonctionnement linéaire, de façon que le transistor puisse dériver des niveaux de courant multiples.

On notera que la prévision d'un circuit d'excitation en courant apte à faire subir à l'élément sous test des variations de courant non binaires, par exemple un circuit du type décrit en relation avec les figures 8 et 9, permet non seulement de réaliser des mesures d'impédance large bande en excitant l'élément par des signaux du type décrit en relation avec les figures 5 à 7, mais aussi d'appliquer d'autres types de signaux d'excitation non binaires, par exemple un signal sinusoïdal permettant de mesurer l'impédance de l'élément à une fréquence particulière précise.

Comme indiqué ci-avant, les dispositifs de mesure d'impédance décrits dans la présente demande peuvent soit être intégrés à un système de gestion de la batterie de type BMS, soit faire partie d'un outil de diagnostic externe. Dans le cas où le dispositif de mesure d'impédance est intégré dans un BMS, une pluralité de circuits d'excitation connectés à des éléments de stockage d'énergie distincts de la batterie peuvent être prévus, par exemple un circuit d'excitation par cellule élémentaire de la batterie. Dans ce cas, les différents circuits d'excitation peuvent soit utiliser la même séquence de variations de courant pour exciter les éléments auxquels ils sont connectés lors d'une mesure d'impédance, soit utiliser des séquences de variations de courant distinctes. L'utilisation de séquences distinctes peut notamment permettre, lorsque la variation de tension résultant d'une excitation en courant est mesurée à distance et non pas directement aux bornes de l'élément lui-même, d'identifier l'élément excité via un circuit de gestion dans lequel sont mémorisées les séquences d'excitation affectées aux différents éléments. La ou les séquences d'excitation en courant des éléments de stockage d'énergie de la batterie peuvent par exemple être stockées sous forme de valeurs numériques de commande dans une mémoire du BMS.

La figure 8 est un schéma électrique illustrant un exemple d'un mode de réalisation d'un dispositif 800 de mesure d'impédance d'un élément de stockage d'énergie d'une batterie.

Le dispositif 800 de la figure 8 comprend des noeuds J5 et J6 destinés à être connectés respectivement à une borne négative et à une borne positive de l'élément de stockage d'énergie (non visible en figure 8) dont on souhaite mesurer l'impédance, par exemple une cellule élémentaire de la batterie. Le dispositif 800 comprend une branche connectée entre les noeuds J6 et J5 (en parallèle de l'élément de stockage d'énergie), comportant, en série entre les noeuds J6 et J5, une résistance R5, un transistor Q1, et une résistance de décharge R4. Dans cet exemple, le transistor Q1 est un transistor bipolaire de type NPN dont le collecteur est connecté à la résistance R5 et dont l'émetteur est connecté à la résistance R4. Les modes de réalisation décrits ne se limitent toutefois pas à ce cas particulier. A titre de variante, un transistor PNP ou un transistor MOS peuvent être utilisés, moyennant d'éventuels ajustements à la portée de l'homme de l'art. La résistance R5 est une résistance de shunt de faible valeur, par exemple inférieure à 10 ohms, utilisée pour mesurer le courant circulant dans le transistor Q1 via un dispositif de mesure de tension (non représenté) connecté aux bornes de la résistance R5 via des noeuds de mesure J8 et J9. Dans l'exemple représenté, le noeud J8 est connecté au collecteur du transistor Q1 et le noeud J9 est connecté au noeud J6.

Le dispositif 800 comprend en outre un amplificateur opérationnel U1 dont un noeud d'alimentation haute J1 est destiné à recevoir un premier potentiel d'alimentation et dont un noeud d'alimentation basse J3 est destiné à recevoir un deuxième potentiel d'alimentation inférieur au premier potentiel. L'alimentation de l'amplificateur U1 peut provenir soit de l'élément dont on souhaite mesurer l'impédance lui-même, soit d'une source extérieure non représentée. Dans l'exemple représenté, le noeud d'alimentation basse J3 est connecté à la masse qui est ici définie par le potentiel bas de l'élément dont on souhaite mesurer l'impédance, c'est-à-dire par le potentiel du noeud J5. L'amplificateur U1 comprend une borne d'entrée inverseuse (-) connectée à l'émetteur du transistor Q1, et une borne de sortie connectée à la base du transistor Q1 par l'intermédiaire d'une résistance R1.

Le dispositif 800 comprend de plus des noeuds J2 et J4 d'application d'une tension de commande. Dans cet exemple, le noeud J4 est relié à la masse. Une résistance R2 et une résistance R3 sont connectées en série entre les noeuds J2 et J4 de façon à former un pont diviseur de tension. Le point milieu de l'association en série des résistances R2 et R3 est connecté à une borne d'entrée non inverseuse (+) de l'amplificateur opérationnel U1.

Lorsqu'une tension de commande VCMD est appliquée entre les noeuds J2 et J4, une tension proportionnelle VCTRL, déterminée par la formule VCTRL = VCMD*(R3/(R2+R3)), est appliquée sur l'entrée non inverseuse de l'amplificateur U1. Cette tension détermine le courant I débité dans le transistor Q1 par l'élément sous test. Ce courant est approximativement égal à VCTRL/R4.

Pour faire subir une séquence prédéterminée de variations de courant à l'élément sous test, on peut prévoir d'appliquer une séquence adaptée de commande en tension entre les noeuds J2 et J4. La séquence de commande en tension peut par exemple être mémorisée sous forme numérique dans une mémoire non représentée du dispositif 800, et être appliquée sur les noeuds J2 et J4 par l'intermédiaire d'un convertisseur numérique-analogique (non représenté).

A titre de variante, les résistances R2 et/ou R3 du dispositif 800 peuvent être remplacées par des potentiomètres à commande numérique ou analogique. Pour faire subir une séquence prédéterminée de variations de courant à l'élément sous test, on peut alors faire varier les valeurs des résistances R2 et/ou R3 selon une séquence de commande adaptée.

L'impédance de l'élément sous test peut être déterminée à partir de la séquence de variations de tension mesurée entre les noeuds J5 et J6 (ou à distance depuis d'autres noeuds de la batterie), et de la variation de courant appliquée qui peut optionnellement être mesurée via la résistance de shunt R5 pour plus de précision (ceci permet notamment de s'affranchir d'un éventuel décalage entre les consignes de variations en courant appliquées par le dispositif 800 et les variations de courant effectivement générées dans l'élément sous test).

Un avantage du dispositif 800 est que la boucle de contre-réaction reliant l'émetteur du transistor Q1 à l'entrée inverseuse de l'amplificateur U1 permet de faire subir une variation de courant précise à l'élément sous-test, indépendamment de son état de charge et donc de la tension à ses bornes.

La figure 9 est un schéma électrique illustrant un autre exemple d'un mode de réalisation d'un dispositif 900 de mesure d'impédance d'un élément de stockage d'énergie d'une batterie.

Le dispositif 900 de la figure 9 comprend des noeuds J5 et J6 destinés à être connectés respectivement à une borne négative et à une borne positive de l'élément de stockage d'énergie (non visible en figure 9) dont on souhaite mesurer l'impédance. Le dispositif 900 comprend une branche connectée entre les noeuds J6 et J5 (en parallèle de l'élément de stockage d'énergie), comportant, en série entre les noeuds J6 et J5, une résistance R5, un transistor Q2, et une résistance de décharge R4. La résistance R5 est une résistance de shunt de faible valeur, par exemple inférieure à 10 ohms, utilisée pour mesurer le courant circulant dans le transistor Q2 via un dispositif de mesure de tension (non représenté) connecté aux bornes de la résistance R5 via des noeuds de mesure J8 et J9. Dans cet exemple, le transistor Q2 est un transistor MOS à canal N dont la source est connectée à la résistance R5 et dont le drain est connecté à la résistance R4. De plus, une résistance R8 relie la grille du transistor Q2 au noeud J5.

Le dispositif 900 comprend en outre un amplificateur opérationnel U1 dont une borne d'alimentation haute est connectée à un noeud N1 et dont une borne d'alimentation basse est connectée au noeud J5 (masse). Dans cet exemple, la borne d'alimentation haute de l'amplificateur U1 (noeud N1) est reliée à sa borne d'alimentation basse (noeud J5) par un condensateur C1. L'amplificateur U1 comprend une borne d'entrée inverseuse (-) connectée au drain du transistor Q2, et une borne de sortie connectée à la grille du transistor Q2.

Le dispositif 900 comprend de plus des noeuds N2 et N3 d'application d'une tension de commande. Dans cet exemple, le noeud N3 est relié à la masse. Une résistance R6 et une résistance R7 sont connectées en série entre les noeuds N2 et N3 de façon à former un pont diviseur de tension. Le point milieu de l'association en série des résistances R6 et R7 est connecté à une borne d'entrée non inverseuse (+) de l'amplificateur opérationnel U1. Dans l'exemple représenté, les résistances R6 et R7 sont des résistances variables (potentiomètres).

Le dispositif 900 comprend en outre un circuit de contrôle U2, par exemple un microcontrôleur, adapté à appliquer une tension de commande VCMD entre les noeuds N2 et N3. Dans cet exemple, le circuit de contrôle U2 est de plus adapté à commander les résistances variables R6 et R7. Le circuit de contrôle U2 comprend une borne d'alimentation haute connectée au noeud N1 et une borne d'alimentation basse connectée à la masse. Dans cet exemple, la borne d'alimentation haute du circuit de contrôle U2 (noeud N1) est reliée à sa borne d'alimentation basse (noeud J5) par un condensateur C2.

Lorsqu'une tension de commande VCMD est appliquée entre les noeuds N2 et N3 par le circuit de contrôle U2, une tension proportionnelle VCTRL, déterminée par la formule VCTRL = VCMD*(R7/(R6+R7)), est appliquée sur l'entrée non inverseuse de l'amplificateur U1. Cette tension détermine le courant I débité dans le transistor Q2 par l'élément sous test. Dans cet exemple, pour faire subir une séquence prédéterminée de variations de courant à l'élément sous test, on peut prévoir de faire varier les valeurs des résistances R6 et/ou R7. A titre de variante, on peut prévoir des résistances R6 et R7 non variables et faire varier le niveau de la tension VCMD.

Le dispositif 900 comprend en outre un circuit d'alimentation 901 comprenant un transistor MOS Q3, par exemple un transistor MOS à canal P, reliant le noeud J6 à un noeud N4, un condensateur C3 reliant le noeud N4 à la masse (noeud J5), une résistance R9 reliant la grille du transistor Q3 à la masse, et un condensateur C4 reliant le noeud N1 à la masse. Le circuit 901 comprend en outre un régulateur de tension U3, par exemple un régulateur de type LDO, dont une entrée VIN est connectée au noeud N4 et dont une sortie VOUT est connectée au noeud N1, ce régulateur comportant en outre une borne de masse GND connectée au noeud J5. La grille du transistor Q3 est connectée à une borne d'entrée/sortie du circuit de contrôle U2 du dispositif 900.

Un avantage du dispositif 900 de la figure 9 est que le circuit d'alimentation 901 peut, avant la mise en oeuvre d'une phase de mesure d'impédance, stocker dans le condensateur C3 l'énergie nécessaire à l'alimentation de l'amplificateur U1, au circuit de contrôle U2, et, le cas échéant, des potentiomètres R6 et R7 (dans le cas de potentiomètres à commande numérique nécessitant une alimentation) pendant une mesure d'impédance. Ainsi, lors d'une mesure d'impédance, l'amplificateur U1 et le circuit de contrôle U2 (et le cas échéant les potentiomètres R6 et R7) peuvent être alimentés par le condensateur C3 au lieu d'être alimentés directement par l'élément sous test. Ceci permet que la mesure d'impédance ne soit pas perturbée par la consommation du circuit d'excitation en courant.

A titre d'exemple, le transistor Q3 peut être maintenu fermé (passant) pendant une phase de charge du condensateur C3 préalable à une phase de mesure d'impédance. Lorsqu'une mesure d'impédance est mise en oeuvre, le circuit de contrôle U2 commence par ouvrir (bloquer) le transistor Q4. Les composants U1 et U2 sont alimentés par l'énergie stockée dans le condensateur C3. Le régulateur U3 fournit sur le noeud N1 une tension adaptée à l'alimentation des composants U1 et U2. Aucune énergie d'alimentation du dispositif 900 n'est alors prélevée dans l'élément sous test. Le circuit de contrôle U2 commande alors l'application de la séquence de variations de courant requise pour la mesure d'impédance. Une fois la mesure terminée, le circuit de contrôle U2 referme le transistor Q3 de façon à recharger le condensateur C3 en vue d'une mesure d'impédance ultérieure.

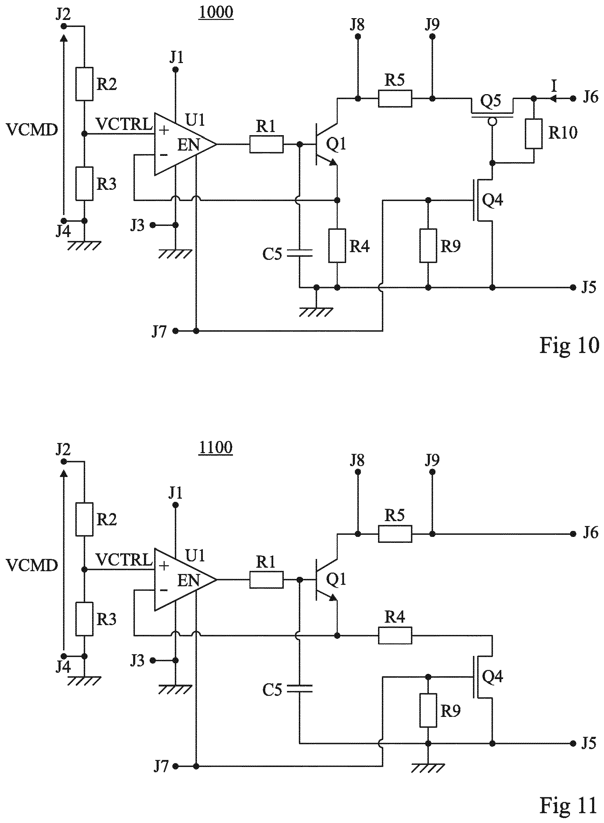

La figure 10 est un schéma électrique illustrant un autre exemple d'un mode de réalisation d'un dispositif 1000 de mesure d'impédance d'un élément de stockage d'énergie d'une batterie.

Le dispositif 1000 de la figure 10 comprend les mêmes éléments que le dispositif 800 de la figure 8, agencés sensiblement de la même manière, et comprend en outre :
un condensateur C5 dont une première électrode est connectée à la base du transistor Q1 et dont la deuxième électrode est connectée au noeud J5 ;
un transistor MOS à canal P Q5 reliant le noeud J6 à la résistance R5, c'est-à-dire dont les noeuds de conduction (source, drain) sont connectés respectivement aux noeuds J6 et J9 ;
une résistance R10 reliant la grille du transistor Q5 au noeud J6 ;
un transistor MOS à canal N Q4 reliant la grille du transistor Q5 au noeud J5 ; et
une résistance R9 reliant la grille du transistor Q4 au noeud J5.

Le dispositif 1000 de la figure 10 comprend en outre un noeud de commande J7 connecté d'une part à la grille du transistor Q4, et d'autre part à un noeud EN d'activation/désactivation de l'amplificateur opérationnel U1.

Comme dans l'exemple de la figure 8, l'élément de batterie à tester est connecté entre les noeuds J5 (borne négative de l'élément) et J6 (borne positive de l'élément).

Les résistances R9 et R10 sont de préférence relativement élevées, par exemple supérieures à 500 kΩ.

Pendant une phase de mesure d'impédance, le dispositif 1000 est rendu actif. Pour cela, un signal binaire appliqué sur le noeud J7 est mis à l'état haut. L'amplificateur U1 est alors actif, et les transistors Q4 et Q5 sont à l'état passant. Le fonctionnement du dispositif 1000 est alors similaire à celui du dispositif 800 de la figure 8.

En dehors des phases de mesure d'impédance, le dispositif 1000 est désactivé par la mise à l'état bas du signal appliqué sur le noeud J7. L'amplificateur U1 est alors inactif, et les transistors Q4 et Q5 sont à l'état non passant (du fait du tirage, respectivement à l'état haut et à l'état bas, des grilles des transistors Q5 et Q4 par les résistances R10 et R9).

Un avantage du dispositif 1000 de la figure 10 est qu'il permet d'éviter, en dehors des phases de mesure d'impédance, une consommation résiduelle parasite de l'énergie stockée dans l'élément de batterie par le dispositif de mesure d'impédance (par exemple du fait de courants de fuite dans le transistor Q1 et/ou d'une tension d'offset non nulle en sortie de l'amplificateur opérationnel U1).

On notera que, dans l'exemple de la figure 10, si l'on souhaite appliquer à l'élément de batterie une séquence binaire de variations de courant, tel que décrit dans la demande de brevet FR1353656 susmentionnée, on peut prévoir de fixer la tension VCTRL à une valeur constante, et d'appliquer la séquence binaire sur le noeud J7. Ceci permet d'augmenter la vitesse de commutation du transistor Q1, en s'affranchissant du temps de réponse de l'amplificateur U1 (qui peut être relativement important). Dans une telle configuration de fonctionnement, la résistance R10 peut toutefois limiter la vitesse de commutation du dispositif. Pour s'affranchir de cette limitation, on peut prévoir de diminuer la valeur de la résistance R10. Alternativement, pour éviter une erreur trop importante sur la mesure d'impédance, le circuit de la figure 10 peut être modifié tel que représenté en figure 11.

La figure 11 est un schéma électrique illustrant un autre exemple d'un mode de réalisation d'un dispositif 1100 de mesure d'impédance d'un élément de stockage d'énergie d'une batterie.

Le dispositif 1100 de la figure 11 comprend les mêmes éléments que le dispositif 800 de la figure 8, agencés sensiblement de la même manière, excepté que la résistance R4 n'est pas connectée directement au noeud J5, mais est reliée au noeud J5 par l'intermédiaire d'un transistor MOS à canal N Q4.

Le dispositif 1100 de la figure 11 comprend en outre un condensateur C5 dont une première électrode est connectée à la base du transistor Q1 et dont la deuxième électrode est connectée au noeud J5, et une résistance R9 reliant la grille du transistor Q4 au noeud J5.

Le dispositif 1100 de la figure 11 comprend de plus un noeud de commande J7 connecté d'une part à la grille du transistor Q4, et d'autre part à un noeud EN d'activation/désactivation de l'amplificateur opérationnel U1.

Le fonctionnement du dispositif 1100 de la figure 11 est similaire à celui du dispositif 1000 de la figure 10. Un avantage est que, lorsqu'il est piloté directement par le noeud J7, le transistor Q4 peut commuter plus rapidement que dans l'exemple de la figure 10.

On notera par ailleurs que dans les exemples des figures 10 et 11, si la réponse en activation/désactivation (via le noeud EN) de l'amplificateur U1 n'est pas suffisamment rapide pour appliquer une séquence binaire de variations de courant, on peut prévoir deux noeuds séparés J7 et J7' reliés respectivement au noeud EN et à la grille du transistor Q4. Pour appliquer une séquence binaire de variations de courant, on peut alors maintenir le signal sur le noeud J7 à l'état haut, et appliquer la séquence binaire sur le noeud J7'.

## Revendications

1. Procédé de détermination de l'impédance d'un élément (100) de stockage d'énergie d'une batterie électrique, comprenant les étapes suivantes :
- appliquer à l'élément (100) une séquence (501) prédéterminée de variations de courant ;
- mesurer les variations de tension aux bornes de l'élément (100) en réponse à l'application de ladite séquence (501) ; et
déterminer l'impédance de l'élément (100) à partir des variations de tension mesurées,
**caractérisé en ce que** ladite séquence (501) est une séquence non binaire obtenue par convolution d'une séquence binaire pseudo-aléatoire (201) avec des coefficients d'un filtre à réponse impulsionnelle finie (400).

2. Procédé selon la revendication 1, dans lequel le filtre (400) est choisi de façon que le spectre en fréquence de ladite séquence (501) présente une bande passante de largeur comprise entre 1 Hz et 50 kHz présentant un niveau approximativement constant, c'est-à-dire variant de moins de 10 dB, et présente une atténuation inférieure à -30 dB en dehors de cette bande passante.

3. Procédé selon la revendication 1 ou 2, dans lequel le filtre (400) est un filtre en racine de cosinus surélevé.

4. Procédé selon la revendication 1 ou 2, dans lequel le filtre (400) est un filtre en cosinus surélevé.

5. Procédé selon l'une quelconque des revendications 1 à 4, dans lequel ladite séquence non binaire (501) est modulée sur un signal porteur périodique avant d'être appliquée à l'élément (100).

6. Procédé selon la revendication 5, dans lequel ledit signal périodique est sinusoïdal.

7. Dispositif (800 ; 900) de détermination de l'impédance d'un élément (100) de stockage d'énergie d'une batterie électrique, comprenant un circuit adapté à :
- appliquer à l'élément une séquence prédéterminée (501) de variations de courant ;
- mesurer les variations de tension aux bornes de l'élément en réponse à l'application de ladite séquence ; et
déterminer l'impédance de l'élément à partir des variations de tension mesurées,
**caractérisé en ce que** ladite séquence (501) est une séquence non binaire obtenue par convolution d'une séquence binaire pseudo-aléatoire (201) avec des coefficients d'un filtre à réponse impulsionnelle finie (400).

8. Dispositif (800 ; 900) selon la revendication 7, dans lequel ledit circuit comprend une branche de décharge destinée à être connectée en parallèle de l'élément, cette branche comportant un transistor (Q1 ; Q2) adapté à être commandé dans une zone de fonctionnement linéaire pour appliquer à l'élément des variations de courant non binaires.

9. Dispositif (800 ; 900) selon la revendication 7 ou 8, dans lequel le transistor (Q1 ; Q2) est commandé par l'intermédiaire d'un amplificateur opérationnel (U1), et dans lequel une boucle de contre-réaction relie ladite branche à une borne d'entrée de l'amplificateur (U1).

10. Dispositif (900) selon l'une quelconque des revendications 7 à 9, dans lequel ledit circuit comprend un circuit d'alimentation (901) adapté à emmagasiner de l'énergie électrique dans un condensateur (C3) avant une phase de mesure d'impédance, en vue d'alimenter le dispositif (900) pendant la phase de mesure.

11. Assemblage comportant :
une batterie électrique comportant au moins un élément (100) de stockage d'énergie ; et
un dispositif de gestion de la batterie couplé à la batterie, ledit dispositif de gestion comportant au moins un dispositif (800 ; 900) selon l'une quelconque des revendications 7 à 10, adapté à mesurer l'impédance de l'élément de stockage (100).

12. Assemblage selon la revendication 11, dans lequel la batterie comporte plusieurs éléments de stockage, et dans lequel le dispositif de gestion comporte plusieurs dispositifs de mesure d'impédance (800 ; 900) affectés respectivement aux différents éléments de stockage, les différents dispositifs de mesure d'impédance étant adaptés à appliquer des séquences de variations de courant différentes aux différents éléments de stockage.

13. Assemblage selon la revendication 12, dans lequel le dispositif de gestion est adapté à identifier les différents éléments par la séquence de variations de courant qui leur est appliquée lors d'une mesure d'impédance.

## Patentansprüche

1. Verfahren zum Bestimmen der Impedanz eines Energiespeicherelements (100) einer elektrischen Batterie, das die folgenden Schritte aufweist:
- Anlegen einer vorbestimmten Sequenz (501) von Stromänderungen auf das Element (100);
- Messen der Spannungsänderungen über dem Element (100) ansprechend auf das Anlegen der Sequenz (501); und
Bestimmen der Impedanz des Elements (100) basierend auf den gemessenen Spannungsänderungen,
wobei die Sequenz (501) eine nicht-binäre Sequenz ist, die durch Faltung einer pseudozufälligen binären Sequenz (201) mit Koeffizienten eines FIR-Filters (= finite impulse response filter) (400) erhalten wird.

2. Verfahren nach Anspruch 1, wobei der Filter (400) so ausgewählt ist, dass das Frequenzspektrum der Sequenz (501) ein Durchlassband mit einer Breite im Bereich von 1 Hz bis 50 kHz mit einem annähernd konstanten Pegel, d.h. mit einer Änderung um weniger als 10 dB, aufweist und eine Dämpfung von weniger als -30 dB außerhalb dieses Durchlassbandes aufweist.

3. Verfahren nach Anspruch 1 oder 2, wobei der Filter (400) ein Root-Raised-Cosine-Filter ist.

4. Verfahren nach Anspruch 1 oder 2, wobei der Filter (400) ein Raised-Cosine-Filter ist.

5. Verfahren nach einem der Ansprüche 1 bis 4, wobei die nichtbinäre Sequenz (501) auf ein periodisches Trägersignal moduliert wird, bevor sie an das Element (100) angelegt wird.

6. Verfahren nach Anspruch 5, wobei das periodische Signal sinusförmig ist.

7. Vorrichtung (800; 900) zum Bestimmen der Impedanz eines Energiespeicherelements (100) einer elektrischen Batterie, die eine Schaltung aufweist, die geeignet ist zum:
- Anlegen einer vorbestimmten Sequenz (501) von Stromänderungen an das Element;
- Messen der Spannungsänderungen über dem Element ansprechend auf das Anlegen der Sequenz; und
Bestimmen der Impedanz des Elements aus den gemessenen Spannungsänderungen,
wobei die Sequenz (501) eine nicht-binäre Sequenz ist, die durch Faltung einer pseudozufälligen binären Sequenz (201) mit Koeffizienten eines FIR-Filters (400) erhalten wird.

8. Vorrichtung (800; 900) nach Anspruch 7, wobei die Schaltung einen Entladungszweig aufweist, der dazu bestimmt ist, parallel mit dem Element verbunden zu werden, wobei dieser Zweig einen Transistor (Q1; Q2) aufweist, der in einem Bereich des linearen Betriebs gesteuert werden kann, um nicht-binäre Stromänderungen an das Element anzulegen.

9. Vorrichtung (800; 900) nach Anspruch 7 oder 8, wobei der Transistor (Q1; Q2) über einen Operationsverstärker (U1) gesteuert wird, und wobei eine Rückkopplungsschleife den Zweig mit einem Eingangsanschluss des Verstärkers (U1) verbindet.

10. Vorrichtung (900) nach einem der Ansprüche 7 bis 9, wobei die Schaltung eine Stromversorgungsschaltung (901) aufweist, die geeignet ist, elektrische Energie in einem Kondensator (C3) vor einer Impedanzmessphase zu speichern, um die Vorrichtung (900) während der Messphase zu betreiben.

11. Anordnung, die folgendes aufweist:
eine elektrische Batterie, die wenigstens ein Energiespeicherelement (100) aufweist; und
eine Vorrichtung zur Verwaltung der mit der Batterie gekoppelten Batterie, wobei die Verwaltungsvorrichtung wenigstens eine Vorrichtung (800; 900) nach einem der Ansprüche 7 bis 10 aufweist, die geeignet ist, die Impedanz des Speicherelements (100) zu messen.

12. Anordnung nach Anspruch 11, wobei die Batterie eine Vielzahl von Speicherelementen aufweist, und wobei die Verwaltungsvorrichtung eine Vielzahl von Impedanzmessvorrichtungen (800; 900) aufweist, die jeweils den verschiedenen Speicherelementen zugeordnet sind, wobei die verschiedenen Impedanzmessvorrichtungen geeignet sind, unterschiedliche Stromänderungssequenzen an die verschiedenen Speicherelemente anzulegen.

13. Anordnung nach Anspruch 12, wobei die Verwaltungsvorrichtung geeignet ist, die verschiedenen Elemente mit der Stromänderungssequenz zu identifizieren, die während einer Impedanzmessung daran angelegt wird.

## Claims

1. A method of determining the impedance of an energy storage element (100) of an electric battery, comprising the steps of:
- applying to the element (100) a predetermined sequence (501) of current variations;
- measuring the voltage variations across the element (100) as a response to the application of said sequence (501) ; and
determining the impedance of the element (100) based on the measured voltage variations,
wherein said sequence (501) is a non-binary sequence obtained by convolution of a pseudo-random binary sequence (201) with coefficients of a finite impulse response filter (400).

2. The method of claim 1, wherein the filter (400) is selected so that the frequency spectrum of said sequence (501) has a pass-band with a width in the range from 1 Hz to 50 kHz having an approximately constant level, that is, varying by less than 10 dB, and has an attenuation lower than -30 dB outside of this pass-band.

3. The method of claim 1 or 2, wherein the filter (400) is a root raised cosine filter.

4. The method of claim 1 or 2, wherein the filter (400) is a raised cosine filter.

5. The method of any of claims 1 to 4, wherein said non-binary sequence (501) is modulated on a periodic carrier signal before being applied to the element (100).

6. The method of claim 5, wherein said periodic signal is sinusoidal.

7. A device (800; 900) for determining the impedance of an energy storage element (100) of an electric battery, comprising a circuit capable of:
- applying to the element a predetermined sequence (501) of current variations;
- measuring the voltage variations across the element as a response to the application of said sequence; and
determining the impedance of the element from the measured voltage variations,
wherein said sequence (501) is a non-binary sequence obtained by convolution of a pseudo-random binary sequence (201) with coefficients of a finite impulse response filter (400).

8. The device (800; 900) of claim 7, wherein said circuit comprises a discharge branch intended to be connected in parallel with the element, this branch comprising a transistor (Q1; Q2) capable of being controlled in an area of linear operation to apply to the element non-binary current variations.

9. The device (800; 900) of claim 7 or 8, wherein the transistor (Q1; Q2) is controlled via an operational amplifier (U1), and wherein a feedback loop connects said branch to an input terminal of the amplifier (U1).

10. The device (900) of any of claims 7 to 9, wherein said circuit comprises a power supply circuit (901) capable of storing electric energy in a capacitor (C3) before an impedance measurement phase, to power the device (900) during the measurement phase.

11. An assembly comprising:
an electric battery comprising at least one energy storage element (100); and
a device for managing the battery coupled to the battery, the management device comprising at least one device (800; 900) of any of claims 7 to 10, capable of measuring the impedance of the storage element (100).

12. The assembly of claim 11, wherein the battery comprises a plurality of storage elements, and wherein the management device comprises a plurality of impedance measurement devices (800; 900) respectively assigned to the different storage elements, the different impedance measurement devices being capable of applying different current variation sequences to the different storage elements.

13. The assembly of claim 12, wherein the management device is capable of identifying the different elements with the current variation sequence which is applied thereto during an impedance measurement.
